# EUROPÄISCHE PATENTSCHRIFT

(11) **EP 1 792 351 B1**
(45) Veröffentlichungstag und Bekanntmachung des Hinweises auf die Patenterteilung: **27.07.2016**
(21) Anmeldenummer: 05798035.1
(22) Anmeldetag: 20.09.2005
(51) Int. Cl.: H01L 33/60, H01L 33/48

(54) **GEHÄUSE FÜR EIN OPTOELEKTRONISCHES BAUELEMENT, OPTOELEKTRONISCHES BAUELEMENT UND VERFAHREN ZUR HERSTELLUNG EINES OPTOELEKTRONISCHEN BAUELEMENTS**
HOUSING FOR AN OPTOELECTRONIC COMPONENT, OPTOELECTRONIC COMPONENT AND METHOD FOR THE PRODUCTION OF AN OPTOELECTRONIC COMPONENT
BOITIER POUR UN COMPOSANT OPTOELECTRONIQUE, COMPOSANT OPTOELECTRONIQUE ET PROCEDE DE PRODUCTION DE CE DERNIER

(30) Priorität: 22.09.2004 DE 102004045950
(43) Veröffentlichungstag der Anmeldung: 06.06.2007
(73) Patentinhaber: OSRAM Opto Semiconductors GmbH, 93055 Regensburg (DE)
(72) Erfinder: BOGNER, Georg, 93138 Lappersdorf (DE); BRUNNER, Herbert, 93161 Sinzing (DE); HIEGLER, Michael, 73557 Mutlangen (DE); WAITL, Günter, 93049 Regensburg (DE)
(74) Vertreter: Epping - Hermann - Fischer
(86) Internationale Anmeldenummer: PCT/DE2005/001654
(87) Internationale Veröffentlichungsnummer: WO 2006/032251

(56) Entgegenhaltungen:
- EP-A- 1 011 151
- EP-A- 1 119 058
- EP-A1- 1 367 413
- WO-A1-02/17405
- WO-A2-02/052615
- DE-A1- 10 122 002
- US-A1- 2001 042 865
- US-A1- 2002 105 268
- US-A1- 2003 025 117
- US-A1- 2003 116 769

## Beschreibung

Die Erfindung betrifft ein Gehäuse für ein optoelektronisches Bauelement, ein optoelektronisches Bauelement, sowie ein Verfahren zur Herstellung eines optoelektronischen Bauelements.

Die Druckschrift WO 02/08 47 49 A2 beschreibt einen Leiterrahmen und ein Gehäuse, sowie ein damit gebildetes strahlungsemittierendes Bauelement. Im Gehäusegrundkörper ist dabei eine Ausnehmung in Form eines Strahlungsaustrittsfensters gebildet, wobei die Seitenwände des Strahlungsaustrittsfensters einen Reflektor bilden.

Die Druckschrift US 2002/0105268 A1 beschreibt eine Leuchtdiode mit einem Reflektor.

Die Druckschrift US 2003/0116769 A1 beschreibt eine Leuchtdiode, bei der ein Reflektor nach Montage eines Leuchtdiodenchips befestigt wird.

Die Druckschrift EP 1 119 058 A1 beschreibt eine Leuchtdiode.

Die Druckschrift US 2003/0025117 A1 beschreibt eine Leuchtdiode mit einem reflektierenden Gehäuse.

Die Druckschrift EP 1 011 151 A2 beschreibt eine Leuchtdiode mit einem Reflektor.

Die Druckschrift DE 101 22 002 A1 beschreibt ein Gehäuse für ein optoelektronisches Bauelement und ein optoelektronisches Bauelement.

Die Druckschrift US 2001/0042865 A1 beschreibt ein Licht emittierendes Halbleiterbauelement mit einem Gehäuse, welches einen Reflektor umfasst.

Die Druckschrift EP 1 367 413 A1 beschreibt eine Beleuchtungsvorrichtung mit einem optischen Element. Das optische Element weist Verbindungsstifte auf, welche ein integraler Bestandteil des optischen Elements sind und in Ausnehmungen in einem Substrat eingepasst sind, so dass das optische Element in Position gehalten wird.

Die Druckschrift WO 02/052615 A2 beschreibt ein strahlungsemittierendes Halbleiterbauelement mit einem Reflektor.

Die Druckschrift WO 02/17405 A1 beschreibt ein optoelektronisches Bauelement mit einem Gehäuserahmen. Der Gehäuserahmen kann als Reflektorrahmen ausgebildet sein und Zapfen umfassen, wobei die Zapfen integraler Bestandteil des Reflektorrahmens sind. Zur Verankerung in einer Chipträgerfolie können in dieser Durchbrüche ausgeformt sein, in welche sich die Zapfen des Reflektorrahmens hinein erstrecken.

Es ist Aufgabe der vorliegenden Erfindung, ein Gehäuse für ein optoelektronisches Bauelement anzugeben, das besonders vielseitig einsetzbar ist. Darüber hinaus ist es Aufgabe der Erfindung, ein optoelektronisches Bauelement mit solch einem Gehäuse, sowie ein Verfahren zur Herstellung solch eines optoelektronischen Bauelements anzugeben.

Diese Aufgaben werden gelöst durch ein Gehäuse nach Patentanspruch 1, ein optoelektronisches Bauelement gemäß Patentanspruch 9 sowie ein Verfahren zur Herstellung eines optoelektronischen Bauelements nach Patentanspruch 10. Vorteilhafte Ausgestaltungen der Erfindung sind Gegenstand der abhängigen Ansprüche.

Es wird ein Gehäuse für ein optoelektronisches Bauelement angegeben. Bevorzugt handelt es sich um ein Gehäuse für ein oberflächenmontierbares optoelektronisches Bauelement.

Das Gehäuse weist einen Träger mit einer Chipmontagefläche auf. Das heißt, auf dem Träger ist eine Fläche vorgesehen, auf die beispielsweise wenigstens ein strahlungsemittierender oder strahlungsempfangender Halbleiterchip montiert werden kann.

Der Träger kann beispielsweise einen Grundkörper aufweisen, der ein elektrisch isolierendes Material enthält. Auf zumindest Teile der Oberfläche des Grundkörpers des Trägers sind dann strukturierte Leiterbahnen, die ein elektrisch leitendes Material enthalten, aufgebracht. Die Chipmontagefläche ist bevorzugt durch zumindest einen Teil der Oberfläche des Trägers gegeben. Die Chipmontagefläche kann beispielsweise durch einen Teil der Leiterbahnen gebildet sein. Über die Leiterbahnen kann ein auf den Träger aufgebrachter Chip elektrisch kontaktiert werden.

Weiter weist das Gehäuse ein optisches Element auf. Bevorzugt ist das optische Element separat vom Träger gefertigt und ist mechanisch an den Träger befestigt. Die Trennebene zwischen Träger und optischem Element ist in der Ebene der Chipmontagefläche angeordnet.

Bevorzugt umschließt das optische Element die Chipmontagefläche zumindest teilweise. Dazu weist das optische Element beispielsweise Seitenwände auf, die die Chipmontagefläche zumindest teilweise umgeben.

Das optische Element ist mittels einer Presspassung mit dem Träger mechanisch verbunden.

Dazu ist im Träger und im optischen Element wenigstens eine Ausnehmung vorgesehen, in die ein Stift eingesetzt ist, der eine größere Ausdehnung als die Ausnehmung im Träger und im optischen Element aufweist, so dass der Stift in die Ausnehmungen eingepresst ist und mechanisch stabil mit dem Träger und dem optischen Element verbunden ist.

Bei den Ausnehmungen kann es sich beispielsweise um Bohrungen handeln. Es ist jedoch auch möglich, dass Ausnehmungen bereits bei der Herstellung von Träger und/oder optischem Element, beispielsweise durch eine entsprechende Form mittels eines der erwähnten Verfahren - wie Spritzgießen oder Spritzpressen, erzeugt werden.

Der Träger kann beispielsweise wenigstens eines der folgenden Materialien enthalten: LCP, PEEK, PPA, Keramiken wie beispielsweise Al₂O₃ oder AlN. Als Vorteil der zweiteiligen Konstruktion ergibt sich dabei, dass das Trägermaterial unabhängig vom Material des optischen Elements gewählt werden kann. Auf diese Weise kann das Trägermaterial hinsichtlich der Anforderungen an den Träger optimiert werden.

Das Gehäuse macht sich dabei die Idee zunutzte, dass sich durch den getrennten Aufbau von Träger und optischem Element zahlreiche neue Designmöglichkeiten für optoelektronische Bauelemente ergeben. So kann beispielsweise bei gleichem Träger durch die Auswahl eines bestimmten optischen Elements die Abstrahlcharakteristik des Bauelements je nach den Einsatzerfordernissen angepasst werden. Da Träger und optisches Element bevorzugt separat gefertigt sind, bieten sich zudem mehr Möglichkeiten bei der Auswahl der Materialsysteme, in denen Träger und optisches Element jeweils gebildet sind.

Das optische Element ist der Chipmontagefläche bevorzugt derart nachgeordnet, dass beispielsweise die Strahlung eines auf die Chipmontagefläche aufgebrachten strahlungsemittierenden Bauelements zumindest teilweise auf zumindest Teilbereiche des optischen Elements trifft.

Gemäß wenigstens einer Ausführungsform des Gehäuses ist zumindest ein Teil des optischen Elements geeignet, elektromagnetische Strahlung zumindest eines bestimmten Wellenlängenbereichs zumindest teilweise zu reflektieren. Umschließen Seitenwände des optischen Elements die Chipmontagefläche zumindest teilweise, so können beispielsweise die Innenwände des optischen Elements, das heißt, zum Beispiel die Innenseiten der Seitenwände, die der Chipmontagefläche nachgeordnet sind, geeignet sein, elektromagnetische Strahlung eines vorgebbaren Wellenlängenbereichs zu reflektieren. Die Abstrahlcharakteristik des optischen Elements kann zum Beispiel durch die Form der Innenwände des optischen Elements sowie die Materialien, die das optische Element enthält, bestimmt sein. Bei dem optischen Element handelt es sich dann zum Beispiel um einen Reflektor.

So ist das optische Element in zumindest einer Ausführungsform ein nichtabbildender optischer Konzentrator, wobei die Lichteingangsöffnung des optischen Elements die eigentliche Lichtausgangsöffnung des Konzentrators ist. Die Lichteingangsöffnung ist bevorzugt der Chipmontagefläche nachgeordnet. Das heißt, der optische Konzentrator verjüngt sich zur Chipmonatefläche hin. Die Querschnittfläche des optischen Konzentrators nimmt dann in Richtung der Chipmontagefläche hin ab. Auf diese Weise kann das optischen Element geeignet sein, die Divergenz eines von einem auf die Chipmontagefläche befestigten strahlungsemittierenden Bauelements emittierten Lichtstrahls beim Durchtritt durch das optische Element zu verringern.

Gemäß wenigstens einer Ausführungsform ist das optische Element zumindest teilweise nach Art eines zusammengesetzten parabolischen Konzentrators (Compound Parabolic Concentrator, CPC), eines zusammengesetzten elliptischen Konzentrators (Compound Elliptic Concentrator, CEC), eines zusammengesetzten hyperbolischen Konzentrators (Compound Hyperbolic Concentrator, CHC) oder einer TIR (Total Internal Reflection) Optik gebildet. Das heißt, beispielsweise reflektierend ausgebildete Innenwände des optischen Elements, die dem Chipmontagebereich nachgeordnet sind, sind zumindest teilweise nach Art eines CPC, CEC, CHC oder einer TIR gebildet. Weiterhin ist es möglich, dass das optische Element durch eine Kombination von wenigstens zwei dieser optischen Elemente gebildet ist.

Gemäß wenigstens einer Ausführungsform weist das optische Element Innenwände auf, die die Lichteingangsöffnung des optischen Elements mit einer Lichtausgangsöffnung verbinden und dabei im Wesentlichen gerade verlaufen. Die Innenwände des optischen Elements bilden dabei beispielsweise einen Pyramidenstumpf oder einen Kegelstumpf. Bevorzugt sind die Innenwände wiederum reflektierend ausgestaltet.

In wenigstens einer Ausführungsform ist das optische Element ein dieelektrischer Konzentrator. Zumindest dessen Seitenwände sind dann aus einem dieelektrischen Material mit geeignetem Brechungsindex gebildet sind, so dass über die Lichteingangsöffnung eintretende Strahlung durch Totalreflexion an den Grenzflächen der Seiten- oder Innenwände zum umgebenden Medium reflektiert wird.

Ferner ist es möglich, dass es sich bei dem optischen Element um eine Freiformoptik handelt. Das heißt, die Form beispielsweise der Innenwände des optischen Elements, die der Chipmontagefläche nachgeordnet sind, ist der gewünschten Abstrahlcharakteristik des Bauelements angepasst. Die Form der Innenwände kann dabei beispielsweise durch Simulationsberechnungen (zum Beispiel Ray-Tracing Methoden) sehr genau bestimmt werden. Aufgrund der getrennten Fertigung von Träger und optischem Element ist es dann besonders einfach möglich, die berechnete Optik herzustellen.

Zudem ist es möglich, dass es sich bei dem optischen Element um eine Linse, ein Linsensystem oder eine andere lichtbrechende Optik handelt. Das heißt, zumindest ein Teil des optischen Elements ist geeignet, durch das optische Element tretende Strahlung zu brechen.

In wenigstens einer Ausführungsform ist der Lichtausgangsöffnung des optischen Elements wenigstens ein zusätzliches optisches Element nachgeordnet, das zur Beugung, Brechung oder Wellenlängen-Konvertierung der aus der Lichtausgangsöffnung austretenden elektromagnetischen Strahlung geeignet ist. Besonders bevorzugt erfüllt das zusätzliche optische Element wenigstens zwei dieser Aufgaben.

Nach zumindest einer Ausführungsform weist das zusätzliche optische Element eine Lichtausgangsfläche auf, die beispielsweise sphärisch oder asphärisch gewölbt sein kann. Beispielsweise ist die Lichtausgangsfläche konvex nach außen gewölbt. Dadurch kann beispielsweise eine Verringerung der Divergenz der aus der Lichtausgangsöffnung des optischen Elements austretenden elektromagnetischen Strahlung erreicht werden.

Bevorzugt ist die Lichtausgangsfläche des zusätzlichen optischen Elements nach Art einer asphärischen Linse gewölbt. Das heißt, die Lichtausgangsöffnung ist eine zur Brechung des austretenden Lichtstrahls dienende optische Fläche, die weder kugelförmig noch eben ist. Besonders bevorzugt kann ein derart gebildetes optisches Element eine Vielzahl von Formparametern aufweisen, wodurch etwa der Größe der Strahlungsauskoppelfläche eines auf die Chipmontagefläche befestigten strahlungsemittierenden Halbleiterchips Rechnung getragen werden kann. Im Gegensatz dazu sind sphärische Linsen für punktförmige Lichtquellen optimal und können bei nicht punktförmigen Lichtquellen signifikant schlechtere Eigenschaften etwa hinsichtlich einer Verringerung der Divergenz des austretenden Lichtbündels aufweisen.

In wenigstens einer Ausführungsform des Gehäuses enthält das optische Element ein reflektierendes Material. Bevorzugt ist das reflektierende Material geeignet, beispielsweise die von einem strahlungsemittierenden Bauelement, das auf der Chipmontagefläche aufgebracht ist, erzeugte elektromagnetische Strahlung zu reflektieren. Das optische Element kann dazu beispielsweise einen Kunststoff enthalten, in den geeignete Farbstoffpigmente eingebracht sind, welche die vom Chip emittierte Strahlung reflektieren. Weiter ist es möglich, dass das optische Element aus einem keramischen Material gebildet ist. Das optische Element kann aber auch in einem Metallgussverfahren aus einem reflektierenden Material hergestellt sein.

Weiter kann der Grundkörper des optischen Elements beispielsweise aus einem nicht reflektierenden Material gebildet sein und die dem Chipmontagebereich nachgeordneten Innenwände des optischen Elements sind mit einer reflektierenden Beschichtung versehen. Die Beschichtung kann dabei wenigstens eines der folgenden Materialien enthalten: Aluminiumoxid, Aluminium, Silizium, Siliziumdioxid, Siliziumnitrid. Die reflektierende Beschichtung kann mittels eines Beschichtungsverfahrens wie beispielsweise gepulster chemischer Dampfphasenepitaxie (PICVD) in definierter Dicke auf die Innenwände des optischen Elements aufgebracht sein. Dabei bedeckt die Beschichtung nicht notwendigerweise die gesamte Fläche der Innenwände.

Es ist zudem möglich, dass das optische Element zum Beispiel nahe an seiner Lichteingangsöffnung nicht reflektierend ausgestaltet ist. Auf diese Weise kann besonders divergente Strahlung, die beispielsweise von einem Halbleiterchip emittiert wird, der auf die Chipmontagefläche aufgebracht ist, am Eintritt in das optische Element gehindert werden.

Vorteilhaft kann die Dicke und Zusammensetzung der reflektierenden Schicht oder Schichten an das in das Gehäuse zu montierende optoelektronische Bauelement angepasst sein. Dabei ist es beispielsweise möglich, dass die Beschichtung farboptimiert ist und Licht einer bestimmten Wellenlänge besonders gut reflektiert.

Besonders vorteilhaft ist die getrennte Herstellung von optischem Element und Träger, da bei der Beschichtung keine Vorkehrung gegen ein Bedecken der Chipmontagefläche oder der Leiterbahnen auf dem Träger mit elektrisch isolierendem oder elektrisch leitendem Material getroffen werden muss, wie es zum Beispiel bei einem einteiligen Gehäuse der Fall ist.

Gemäß wenigstens einer Ausführungsform des Gehäuses enthält das optische Element ein Material, das geeignet ist, eine Haftung zwischen dem optischen Element und einem Vergussmaterial, das beispielsweise den auf die Chipmontagefläche montierten Chip zumindest teilweise umgibt, zu vermitteln. Das Material kann als dünne Schicht auf die Innenwände des optischen Elements, die dem Chipmontagebereich nachgeordnet sind, aufgebracht sein. Enthält die Vergussmasse beispielsweise Silikon, so ist eine Beschichtung, die Siliziumdioxid enthält, besonders gut geeignet, die Haftung der Vergussmasse am optischen Element zu erhöhen. Beispielsweise wird die Silikatschicht mittels Flammenpyrolyse auf die Innenwände des optischen Elements aufgebracht.

Entsprechend zumindest einer Ausführungsform des Gehäuses für ein optoelektronisches Bauelement ist es möglich, dass das optische Element ein Lumineszenzkonversionsmaterial enthält. Das Lumineszenzkonversionsmaterial ist geeignet, zumindest einen Teil der elektromagnetischen Strahlung, die beispielsweise von einem Halbleiterchip emittiert wird, der auf die Chipmontagefläche aufgebracht ist, Wellenlängen zu konvertieren. Das Lumineszenzkonversionsmaterial enthält dazu wenigstens eine Art von Leuchtstoffpartikeln. Besonders gut eignen sich beispielsweise anorganische Leuchtstoffe wie seltene Erden, dotierte Granate, oder organische Leuchtstoffe wie Perylen-Leuchtstoffe. Weitere geeignete Leuchtstoffe sind beispielsweise in der Druckschrift WO 98/12 757 aufgeführt, deren Inhalt hinsichtlich der Leuchtstoffe durch Rückbezug aufgenommen wird.

Mit Hilfe des Lumineszenzkonversionsmaterials kann entweder durch weitgehend vollständige Konversion einer Primärstrahlung oder durch gezielte teilweise Konversion und Mischung von Primärstrahlung und konvertierter Strahlung sichtbares Licht eines gewünschten Farbortes auf der CIE-Farbtafel, insbesondere weißes Licht erzeugt werden.

Das Lumineszenzkonversionsmaterial kann beispielsweise als dünne Schicht auf die Innenwände des optischen Elements aufgebracht sein. Die Lumineszenzkonversionsschicht enthält dabei vorteilhaft ein Lumineszenzkonversionsmaterial-Matrixgemisch. Die Matrix enthält beispielsweise duroplastische Polymere oder Silikon. Das Lumineszenzkonversionsmaterial kann in im Wesentlichen gleichmäßiger Konzentration beispielsweise auf den Innenwänden des optischen Elements aufgebracht sein. Es ist aber auch möglich, dass die Konzentration von Lumineszenzkonversionsmaterial in definierten Bereichen des optischen Elements erhöht ist und in anderen Bereichen des optischen Elements verringert ist. Es ist zudem möglich, dass das optische Element Bereiche aufweist, die kein Lumineszenzkonversionsmaterial enthalten. Durch die definierte Einstellung der Konzentration von Lumineszenzkonversionsmaterial beispielsweise auf den Innenwänden des optischen Elements ist eine definierte Konversion der elektromagnetischen Strahlung erreicht.

In wenigstens einer Ausführungsform des Gehäuses enthält das optische Element besonders temperaturbeständige Materialien wie beispielsweise LCP (Liquid Crystal Polymer), PEEK (Polyetheretherketon) oder PPA (Polyphthalamid).

Das optische Element kann dabei beispielsweise durch Spritzguss- oder Spritzpressverfahren gebildet sein. Zur Bildung einer reflektiven Optik können wie oben beschrieben beispielsweise die Innenwände des optischen Elements, die der Chipmontagefläche nachgeordnet sind, mit einem reflektierenden Material beschichtet sein.

Es wird weiter ein optoelektronisches Bauelement mit einem der oben beschriebenen Gehäuse angegeben.

Gemäß mindestens einer Ausführungsform des optoelektronischen Bauelements weist das Bauelement wenigstens einen Leuchtdiodenchip auf, bei dem ein Grossteil der im Leuchtdiodenchip erzeugten elektromagnetischen Strahlung durch eine Strahlungsauskoppelfläche in Hauptabstrahlrichtung austritt. Besonders bevorzugt tritt elektromagnetische Strahlung ausschließlich durch die Strahlungsauskoppelfläche aus.

Der Leuchtdiodenchip enthält einen epitaktisch gewachsenen Schichtstapel. Der Schichtstapel ist beispielsweise eine Abfolge von epitaktisch gewachsenen Schichten. Bevorzugt umfasst der Schichtstapel wenigstens eine aktive Zone, die zur Erzeugung elektromagnetischer Strahlung geeignet ist. Die Strahlungsauskoppelfläche ist dann vorzugsweise durch eine Hauptfläche des Chips gebildet, die sich parallel oder im Wesentlichen parallel zu den Schichten des Schichtstapels erstreckt.

Dazu kann die aktive Zone beispielsweise einen pn-Übergang, eine Doppelheterostruktur, eine Einfach-Quantentopf- oder besonders bevorzugt eine Mehrfach-Quantentopfstruktur (MQW) aufweisen.

Die Bezeichnung Quantentopfstruktur umfasst im Rahmen der Anmeldung auch jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Vom Schichtstapel ist das Aufwachssubstrat nach Abschluss des epitaktischen Wachstums entfernt worden. Besonders bevorzugt ist auf die dem ursprünglichen Aufwachssubstrat abgewandte Oberfläche des Schichtstapels ein Träger aufgebracht. Bauteile, die unter Entfernen des Aufwachssubstrats von einer epitaktisch gewachsenen Schichtfolge hergestellt sind, werden oftmals auch mit dem Oberbegriff Dünnfilmschicht-Bauteile bezeichnet.

Ein Grundprinzip eines Dünnfilmschichtbauteils ist beispielsweise in I. Schnitzer at al., Appl. Phys. Lett. 63(16), 18. Oktober 1993, Seiten 2174 bis 2176, beschrieben, deren Offenbarungsgehalt bezüglich des Grundprinzips von Dünnfilmschichtbauteilen hiermit durch Rückbezug aufgenommen wird.

Ein Dünnfilmleuchtdiodenchip ist in guter Näherung ein Lambertscher Oberflächenstrahler und eignet sich von daher besonders gut beispielsweise für die Anwendung in einem Scheinwerfer.

Besonders vorteilhaft ist, dass der Träger des Dünnfilmschichtbauteils verglichen mit einem Aufwachssubstrat relativ frei gewählt werden kann. So kann der Träger hinsichtlich mancher Eigenschaften wie etwa Leitfähigkeit oder Stabilität für das Bauteil besser geeignet sein, als verfügbare Aufwachssubstrate, die zur Herstellung hochwertiger, epitaktisch gewachsener Schichtfolgen engen Einschränkungen unterliegen. So muss, um hochwertige epitaktische Schichten zu erhalten, das epitaktisch abgeschiedene Material beispielsweise gitterangepasst zum Aufwachssubstrat sein.

Bevorzugt zeichnet sich der auf dem Schichtstapel aufgebrachte Träger durch einen an den Schichtstapel angepassten thermischen Ausdehnungskoeffizienten aus. Beispielsweise kann der Träger ein Halbleitermaterial wie Germanium, Gallium-Arsenid, Gallium-Nitrid, Silizium-Karbid und andere Materialien wie Saphir, Molybdän oder Metalle enthalten.

Außerdem zeichnet sich der Träger bevorzugt durch eine besonders gute thermische Leitfähigkeit aus, so dass die bei der Erzeugung von elektromagnetischer Strahlung in der aktiven Zone entstehende Wärme zumindest teilweise über den Träger an die Umgebung abgegeben werden kann.

Gemäß wenigstens einer bevorzugten Ausgestaltung des Leuchtdiodenchips ist zwischen dem aufgebrachten Träger und dem Schichtstapel eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln ereichen.

Bevorzugt ist der Leuchtdiodenchip auf die Chipmontagefläche des Trägers aufgebracht. Beispielsweise kann der Leuchtdiodenchip auf die Chipmontagefläche aufgelötet oder thermisch beständig aufgeklebt sein.

In wenigstens einer Ausführungsform des optoelektronischen Bauelements weist das optische Element eine Lichteingangsöffnung auf, durch die ein Großteil der im Leuchtdiodenchip erzeugten elektromagnetischen Strahlung in die Optik eintritt. Die Lichteingangsöffnung ist dabei bevorzugt der Strahlungsauskoppelfläche des Leuchtdiodenchips in Hauptabstrahlrichtung nachgeordnet. Die Hauptabstrahlrichtung des Leuchtdiodenchips verläuft dabei beispielsweise im Wesentlichen senkrecht zur Strahlungsauskoppelfläche.

Bevorzugt weist die Lichteingangsöffnung eine Fläche auf, die maximal zweimal so groß, bevorzugt maximal 1,5, besonders bevorzugt maximal 1,25-mal so groß wie die Strahlungsauskoppelfläche des Leuchtdiodenchips ist. Eine solch kleine Lichteingangsöffnung der reflektiven Optik erlaubt beispielsweise eine signifikante Miniaturisierung der Leuchtdiodenanordnung. Die zweiteilige Gehäusekonstruktion erlaubt es dabei, die Optik sehr chipnah zu platzieren. Dies führt vor allem in Verbindung mit einem Leuchtdiodenchip in Dünnfilmbauweise zu einer Effizienzsteigerung des optoelektronischen Bauelements, da keine oder nur kaum Strahlung vor dem Eintritt in das optische Element beispielsweise als Streustrahlung verloren geht.

Zudem ist eine derart kleine Lichteingangsöffnung besonders gut geeignet, den Raumwinkel, in dem die elektromagnetische Strahlung vom Leuchtdiodenchip emittiert wird, mittels des optischen Elements zu verkleinern, da nahe an der Strahlungsauskoppelfläche des Halbleiterchips die Querschnittsfläche des Strahlenkegels der emittierten Strahlung besonders klein ist. Dies ist insbesondere dann vorteilhaft, wenn das Bauelement geeignet sein soll, eine möglichst hohe Strahlungsstärke auf eine möglichst kleine Fläche zu projizieren.

Eine wichtige Erhaltungsgröße in der geometrischen Optik ist dabei das Etendue, d.h. die Strahldichte. Sie ist das Produkt aus dem Flächeninhalt einer Lichtquelle und dem Raumwinkel, in den sie abstrahlt. Die Erhaltung des Etendue hat unter anderem zur Konsequenz, dass man das Licht einer diffusen Strahlungsquelle, zum Beispiel einer Halbleiterleuchtdiode, nicht mehr konzentrieren, d.h. nicht mehr auf eine Fläche mit kleinerer Ausdehnung umlenken kann. Daher ist es vorteilhaft, wenn das Strahlungsbündel mit einem möglichst kleinen Querschnitt in das optische Element eintritt.

Es wird weiter ein Verfahren zur Herstellung eines optoelektronischen Bauelements angegeben.

Gemäß zumindest einer Ausführungsform des Verfahrens wird in einem ersten Verfahrensschritt ein Halbleiterchip auf einem Träger befestigt. Bei dem Träger handelt es sich beispielsweise um einen wie weiter oben beschriebenen Träger, auf beispielsweise dessen Oberfläche Leiterbahnen zum elektrischen Kontaktieren des Chips vorgesehen sind. Bei dem Halbleiterchip handelt es sich bevorzugt um einen Leuchtdiodenchip in Dünnfilmbauweise.

Im folgenden Verfahrensschritt wird der Halbleiterchip elektrisch an den Träger angeschlossen. Dies kann beispielsweise mittels Die- und Wirebonding geschehen.

In einem weiteren Verfahrensschritt wird ein optisches Element auf dem Träger befestigt. Bevorzugt handelt es sich bei dem optischen Element um eines der oben beschriebenen optischen Elemente. Das optische Element wird mittels einer Presspassung mechanisch mit dem Träger verbunden. Die Trennebene zwischen optischem Element und Träger liegt bevorzugt in der Ebene der Chipmontagefläche, das heißt der Fläche des Trägers, auf die der Chip montiert ist.

Wichtig ist beim beschriebenen Verfahren, dass die elektrische Kontaktierung vor der Montage des optischen Elements erfolgt. Im Gegensatz zu Bauelementen bei denen Träger und optisches Element einteilig ausgebildet sind, kann die Kontaktierung beispielsweise mittels Wirebonding besonders einfach erfolgen, da ausreichend Platz für beispielsweise eine Wirebonding-Düse vorhanden ist. Das optische Element kann im Folgenden besonders nahe an den Chip und damit an die Strahlungsauskoppelfläche des Chips gebracht werden, da kein zusätzlicher Platz für die Chipmontage freigehalten werden muss. Auf diese Weise lassen sich Leuchtdiodenchips mit optimierter Etendue herstellen. Das heißt, zum Beispiel ein Reflektor wird erst nach der Montage und Kontaktierung der Chips auf den Träger aufgebracht.

In folgenden Verfahrensschritten kann der Leuchtdiodenchip beispielsweise noch von einer Vergussmasse, die beispielsweise ein Epoxie- und/oder Silikonmaterial enthält, zumindest teilweise umschlossen werden. Die Vergussmasse benetzt dabei bevorzugt auch zumindest Teile der Innenwände des optischen Elements sowie des Trägers. Auf diese Weise kann zusätzlich der mechanische Halt zwischen optischem Element und Träger erhöht werden.

Im Folgenden wird das hier beschriebene Gehäuse für ein optoelektronisches Bauelement sowie das optoelektronische Bauelement anhand von Ausführungsbeispielen und den dazugehörigen Figuren näher erläutert.
Figur 1 zeigt eine schematische Schnittdarstellung eines Beispiels des hier beschriebenen optoelektronischen Bauelements.
Figur 2 zeigt eine schematische Schnittdarstellung eines Beispiels des hier beschriebenen optoelektronischen Bauelements.
Figur 3 zeigt eine schematische Schnittdarstellung eines Ausführungsbeispiels des hier beschriebenen optoelektronischen Bauelements gemäß der Erfindung.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

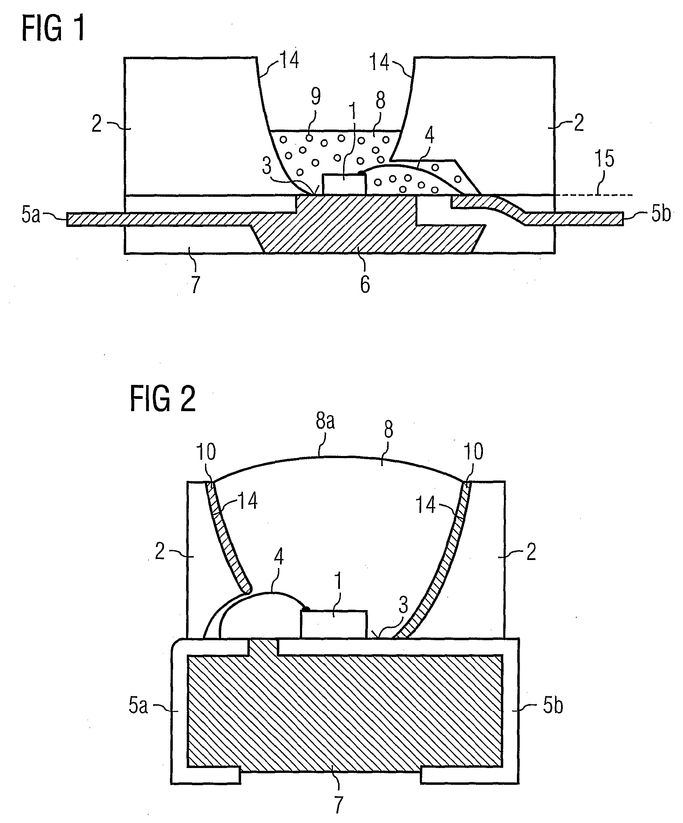

Figur 1 zeigt eine schematische Schnittdarstellung eines hier beschriebenen optoelektronischen Bauelements.

Ein Leuchtdiodenchip 1 ist hier auf die Chipmontagefläche 3 eines Trägers 7 aufgebracht. Ein externes elektrisches Anschlussteil 5a ist elektrisch mit einem thermischen Anschlussteil 6 verbunden, das am Träger 7 befestigt ist. Der Leuchtdiodenchip 1 ist beispielsweise auf das thermische Anschlussteil 6 gelötet und über das thermische Anschlussteil 6 mit dem externen elektrischen Anschlussteil 5a elektrisch verbunden.

Das thermische Anschlussteil 6 ist bevorzugt so geformt, dass es nach Art einer Niete mit dem Träger 7 verbunden werden kann. Gegebenenfalls genügt auch die Verformung einzelner Stege oder Streben des Anschlussteils 6, um eine Quetschverbindung ausreichender Festigkeit zwischen dem Anschlussteil 6 und dem Träger 7 zu bilden. Alternativ kann die Verbindung zwischen Anschlussteil 6 und Träger 7 beispielsweise durch eine Löt-, Schweiß- oder Klebeverbindung gegeben sein.

Das thermische Anschlussteil 6 wirkt im Sinne eines Wärmeleitelements und führt die bei Betrieb im Chip 1 erzeugte Wärme auf die dem Chip abgewandte Seite des Trägers 7 ab. Das thermische Anschlussteil 6 kann an der dem Chip 1 abgewandten Seite des Trägers 7 beispielsweise mit einem Kühlkörper (nicht dargestellt), der als Wärmesenke fungiert, in thermischem Kontakt stehen. Der Träger 7 kann in diesem Ausführungsbeispiel zum Beispiel als Leiterrahmen (Leadframe) ausgeführt sein.

Über einen Wirebondingdraht 4 ist der Chip 1 zusätzlich elektrisch mit dem externen elektrischen Anschlussteil 5b verbunden.

Auf dem Träger 7 ist das optische Element 2 aufgebracht. Das optische Element 2 kann wie im allgemeinen Teil der Beschreibung ausgeführt mittels Presspassung mit dem Träger 7 verbunden sein. Die Trennebene 15 zwischen Träger 7 und optischem Element 2 liegt dabei in der Ebene der Chipmontagefläche 3.

Das optische Element ist beispielsweise eine reflektive Optik wie sie weiter oben beschrieben ist. Die Innenwände 14 des optischen Elements sind dazu zum Beispiel nach Art einer CPC Optik geformt. Beispielsweise kann die vom Leuchtdiodenchip abgegebene elektromagnetische Strahlung mittels Reflektion und/oder Totalreflexion an den Innenwänden 14 reflektiert werden.

Der Chip 1 kann zusätzlich zumindest teilweise von einer Vergussmasse 8 umgeben sein. Die Vergussmasse 8 stabilisiert einerseits die mechanische Verbindung zwischen Träger 7 und optischem Element 2 und bietet andererseits einen mechanischen Schutz des Leuchtdiodenchips 1.

In die Vergussmasse 8 kann ein Lumineszenzkonversionsmaterial 9 eingebracht sein, das geeignet ist, die vom Leuchtdiodenchip 1 abgegebene elektromagnetische Strahlung zumindest teilweise Wellenlängen zu konvertieren. Es ist jedoch auch möglich, dass das Lumineszenzkonversionsmaterial als dünne Schicht auf die Strahlungsauskoppelfläche des Leuchtdiodenchips 1 aufgebracht ist. Weiter kann das Lumineszenzkonversionsmaterial als dünne Schicht auf die Innenwände 14 des Reflektors 2 aufgebracht sein.

In Figur 2 ist eine schematische Schnittdarstellung eines Beispiels des hier beschriebenen oberflächenemittierenden Bauelements gezeigt. Hier ist auf die dem Leuchtdiodenchip 1 nachgeordneten Innenwände 14 des optischen Elements 2 eine Beschichtung 10 aufgebracht, die wenigstens eines der folgenden Materialien enthalten kann:
Lumineszenzkonversionsmaterial, reflektierendes Material, Material das geeignet ist, die Haftung zwischen den Innenwänden 14 des optischen Elements 2 und der Vergussmasse 8 zu erhöhen. Für eine silikonhaltige Vergussmasse 8 eignet sich dazu zum Beispiel ein Silikat. Bevorzugt enthält die Beschichtung 10 eine Kombination wenigstens zweier dieser Materialien.

Zusätzlich kann die Vergussmasse 8 eine Strahlungsauskoppelfläche 8a aufweisen, die eine definierte Krümmung aufweist und damit ein linsenartiges zusätzliches optisches Element bildet, wie es beispielsweise im allgemeinen Teil beschrieben ist. Mittels Brechungsindex der Vergussmasse 8 und Krümmung der Strahlungsauskoppelfläche 8a kann damit eine definierte Abstrahlcharakteristik des optoelektronischen Bauelements eingestellt werden.

Wird als Träger 7 ein besonders gut wärmeleitendes Material verwendet, kann zudem auf die Verwendung eines separaten thermischen Anschlussteils 6 verzichtet werden. Der Träger 7 kann dabei zum Beispiel ein keramisches Material enthalten.

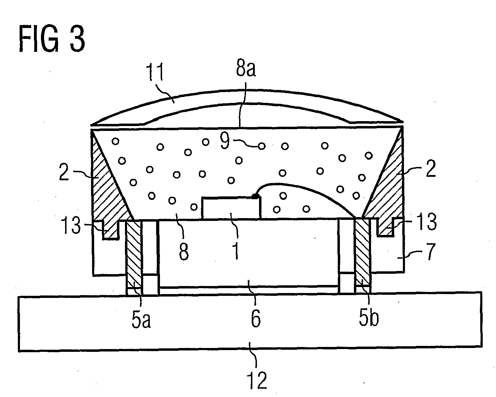

Figur 3 zeigt eine schematische Schnittdarstellung eines Ausführungsbeispiels des hier beschriebenen optoelektronischen Bauelements gemäß der Erfindung. Das optoelektronische Bauelement ist hier beispielsweise auf eine Leiterplatte 12 aufgebracht. Die Leiterplatte 12 ist beispielsweise eine bedruckte Leiterplatte (PCB) oder eine Metallkernplatine. Das Bauelement ist thermisch und elektrisch mit der Leiterplatte 12 beispielsweise mittels eines Lötverfahrens verbunden. Die Leiterplatte 12 dient dabei beispielsweise als Kühlkörper im Sinne einer Wärmesenke für die vom Leuchtdiodenchip 1 über das thermische Anschlussteil 6 abgegebene Wärme.

Der Strahlungsauskoppelfläche 8a der Vergussmasse 8 ist in diesem Ausführungsbeispiel ein zusätzliches optisches Element 11 nachgeordnet, wie es beispielsweise im allgemeinen Teil beschrieben ist. Bei dem zusätzlichen optischen Element 11 kann es sich beispielsweise um eine defraktive, eine refraktive, eine holographische oder eine Fresnel-Optik handeln, mittels derer die Abstrahlcharakteristik des Bauelements definiert eingestellt werden kann.

Zusätzlich kann das zusätzliche optische Element 11 ein Lumineszenzkonversionsmaterial 9 enthalten, das geeignet ist, die vom Leuchtdiodenchip abgegebene elektromagnetische Strahlung Wellenlänge zu konvertieren.

In Figur 3 sind zusätzlich Stifte 13 gezeigt, mittels derer das optische Element 2 mit dem Träger 7 durch eine Presspassung mechanisch stabil verbunden ist. Bei den Stiften 13 handelt es sich um separate Elemente, welche in Ausnehmungen im Träger 7 und im optischen Element 2 eingepresst sind. Der Reflektor 2 kann dabei wie weiter oben beschrieben beschichtet sein.

Diese Patentanmeldung beansprucht die Priorität der deutschen Patentanmeldung 102004045950.9, deren Offenbarungsgehalt hiermit durch Rückbezug aufgenommen wird.

## Patentansprüche

1. Gehäuse für ein optoelektronisches Bauelement, aufweisend
- einen Träger (7) mit einer Chipmontagefläche (3), und
- ein optisches Element (2), wobei die Trennebene (15) zwischen Träger (7) und optischem Element (2) in der Ebene der Chipmontagefläche (3) angeordnet ist, **dadurch gekennzeichnet, dass**
das optische Element (2) mittels einer Presspassung mit dem Träger (7) mechanisch verbunden ist, wobei im Träger (7) und im optischen Element (2) wenigstens eine Ausnehmung vorgesehen ist, in die ein Stift (13) eingesetzt ist, der eine größere Ausdehnung als die Ausnehmung im Träger (7) und im optischen Element (2) aufweist, so dass der Stift (13) in die Ausnehmungen eingepresst ist und mechanisch stabil mit dem Träger (7) und dem optischen Element (2) verbunden ist.

2. Gehäuse nach Anspruch 1,
bei dem zumindest Teile des optischen Elements (2) geeignet sind, elektromagnetische Strahlung eines vorgebbaren Wellenlängenbereichs zu reflektieren.

3. Gehäuse nach Anspruch 1 oder 2,
bei dem das optische Element (2) zumindest teilweise nach Art wenigstens eines der folgenden optischen Elemente gebildet ist: CPC, CEC, CHC, TIR.

4. Gehäuse nach einem der Ansprüche 1 bis 3,
bei dem das optische Element (2) ein reflektierendes Material enthält.

5. Gehäuse nach einem der Ansprüche 1 bis 4,
bei dem das optische Element (2) ein Material enthält, das geeignet ist, eine Haftung zwischen Innenwänden (14) des optischen Elements (2) und einem Vergussmaterial (8) zu vermitteln.

6. Gehäuse nach einem der Ansprüche 1 bis 5,
bei dem das optische Element (2) ein Lumineszenzkonversionsmaterial (9) enthält.

7. Gehäuse nach einem der Ansprüche 1 bis 5,
bei dem ein Lumineszenzkonversionsmaterial (9) in einer Schicht zumindest stellenweise auf Innenwände (14) des optischen Elements (2) aufgebracht ist.

8. Gehäuse nach einem der Ansprüche 1 bis 7, bei dem das optische Element (2) wenigstens eines der folgenden Materialien enthält: Aluminium, Aluminiumoxid, LCP, PEEK, PPA, Siliziumdioxid, Siliziumnitrid.

9. Optoelektronisches Bauelement aufweisend ein Gehäuse nach einem der Ansprüche 1 bis 8,
und wenigstens einen Leuchtdiodenchip (1), wobei der Leuchtdiodenchip (1) einen epitaktisch gewachsenen Schichtstapel aufweist, von dem das Aufwachssubstrat entfernt ist.

10. Verfahren zur Herstellung eines optoelektronischen Bauelements mit den folgenden Schritten:
a) Befestigen eines Halbleiterchips (1) auf einem Träger (7);
b) elektrisches Kontaktieren des Halbleiterchips (1),
c) Befestigen eines optischen Elements (2) auf dem Träger(7), **dadurch gekennzeichnet, dass** das optische Element (2) im Verfahrensschritt c) mittels einer Presspassung mit dem Träger (7) mechanisch verbunden wird, wobei im Träger (7) und im optischen Element (2) wenigstens eine Ausnehmung vorgesehen ist, in die ein Stift (13) eingesetzt wird, der eine größere Ausdehnung als die Ausnehmung im Träger (7) und im optischen Element (2) aufweist, so dass durch ein Einpressen des Stifts (13) in die Ausnehmungen der Stift (13) mechanisch stabil mit dem Träger (7) und dem optischen Element (2) verbunden wird.

11. Verfahren nach Anspruch 10,
wobei der Halbleiterchip (1) im Verfahrenschritt b) mittels Wirebonding (4) kontaktiert wird.

12. Verfahren nach einem der Ansprüche 10 oder 11,
wobei vor Verfahrenschritt c) eine reflektierende Beschichtung auf die Innenwände (14) des optischen Elements (2) aufgebracht wird.

13. Verfahren nach Anspruch 12,
wobei die reflektierende Beschichtung mittels gepulster chemischer Dampfphasenepitaxie (PICVD) aufgebracht wird.

14. Verfahren nach einem der Ansprüche 10 bis 13,
wobei vor Verfahrenschritt c) eine Schicht auf die Innenwände (14) des optischen Elements (2) aufgebracht wird, die ein Lumineszenzkonversionsmaterial (9) umfasst.

15. Verfahren nach einem der Ansprüche 10 bis 14,
wobei vor Verfahrenschritt c) eine Schicht (10) auf die Innenwände (14) des optischen Elements (2) aufgebracht wird, die einen Haftvermittler umfasst.

16. Verfahren nach Anspruch 15,
wobei der Haftvermittler mittels Flammenpyrolyse auf die Innenwände (14) des optischen Elements aufgebracht wird.

## Claims

1. Housing for an optoelectronic component, which includes
- a carrier (7) with a chip mounting surface (3), and
- an optical element (2), the dividing plane (15) between carrier (7) and optical element (2) being arranged in the plane of the chip mounting surface (3), **characterized in that** the optical element (2) is mechanically connected to the carrier (7) by way of a press fit, wherein, in the carrier (7) and in the optical element (2), there is provided at least one recess into which there is inserted a pin (13) which has a larger extent than the recess in the carrier (7) and in the optical element (2), such that the pin (13) is pressed into the recesses and is connected in mechanically stable fashion to the carrier (7) and to the optical element (2).

2. Housing according to Claim 1, in which at least parts of the optical element (2) are suitable for reflecting electromagnetic radiation of a predeterminable wavelength range.

3. Housing according to Claim 1 or 2, in which the optical element (2) is at least partially formed in the style of at least one of the following optical elements: CPC, CEC, CHC, TIR.

4. Housing according to one of Claims 1 to 3, in which the optical element (2) contains a reflective material.

5. Housing according to one of Claims 1 to 4, in which the optical element (2) contains a material which is suitable for producing bonding between inner walls (14) of the optical element (2) and a potting material (8).

6. Housing according to one of Claims 1 to 5, in which the optical element (2) contains a luminescence conversion material (9).

7. Housing according to one of Claims 1 to 5, in which a luminescence conversion material (9) is applied in a layer at least to parts of inner walls (14) of the optical element (2).

8. Housing according to one of Claims 1 to 7, in which the optical element (2) contains at least one of the following materials: aluminium, aluminium oxide, LCP, PEEK, PPA, silicon dioxide, silicon nitride.

9. Optoelectronic component, which includes a housing according to one of Claims 1 to 8 and at least one light-emitting diode chip (1), wherein the light-emitting diode chip (1) has an epitaxially grown layer stack from which the growth substrate is removed.

10. Method for producing an optoelectronic component, comprising the following steps:
a) mounting a semiconductor chip (1) on a carrier (7),
b) electrically contact-connecting the semiconductor chip (1),
c) mounting an optical element (2) on the carrier (7), **characterized in that** the optical element (2) is mechanically connected to the carrier (7) by means of a press fit in method step c), wherein, in the carrier (7) and in the optical element (2), there is provided at least one recess into which there is inserted a pin (13) which has a larger extent than the recess in the carrier (7) and in the optical element (2), such that, as a result of the pin (13) being pressed into the recesses, the pin (13) is connected in mechanically stable fashion to the carrier (7) and to the optical element (2).

11. Method according to Claim 10, in which the semiconductor chip (1) is contact-connected by means of wire bonding (4) in method step b).

12. Method according to either of Claims 10 or 11, in which a reflective coating is applied to the inner walls (14) of the optical element (2) prior to method step c).

13. Method according to Claim 12, in which the reflective coating is applied by means of pulsed chemical vapour phase epitaxy (PICVD).

14. Method according to one of Claims 10 to 13, in which a layer which comprises a luminescence conversion material (9) is applied to the inner walls (14) of the optical element (2) prior to method step c).

15. Method according to one of Claims 10 to 14, in which a layer (10) which comprises a bonding agent is applied to the inner walls (14) of the optical element (2) prior to method step c).

16. Method according to Claim 15, in which the bonding agent is applied to the inner walls (14) of the optical element by means of flame pyrolysis.

## Revendications

1. Boîtier pour un composant optoélectronique comportant
- un support (7) avec une surface de montage de puce (3), et
- un élément optique (2), le plan de séparation (15) entre le support (7) et l'élément optique (2) étant disposé dans le plan de la surface de montage de puce (3), **caractérisé en ce que**
l'élément optique (2) est mécaniquement relié au support (7) au moyen d'un ajustage serré, au moins une cavité étant prévue dans le support (7) et dans l'élément optique (2), dans laquelle cavité est insérée une tige (13), qui comporte une extension plus grande que la cavité dans le support (7) et dans l'élément optique (2) de manière que la tige (13) est enfoncée dans les cavités et est reliée mécaniquement de façon stable au support (7) et à l'élément optique (2).

2. Boîtier selon la revendication 1 pour lequel au moins des parties de l'élément optique (2) sont adaptées pour réfléchir un rayonnement électromagnétique d'une gamme de longueurs d'ondes préalablement définissable.

3. Boîtier selon la revendication 1 ou 2 pour lequel l'élément optique (2) est formé au moins en partie selon le type d'au moins un des éléments optiques suivants : CPC, CEC, CHC, TIR.

4. Boîtier selon l'une quelconque des revendications 1 à 3 pour lequel l'élément optique (2) contient un matériau réfléchissant.

5. Boîtier selon l'une quelconque des revendications 1 à 4 pour lequel l'élément optique (2) contient un matériau qui est adapté pour transmettre une adhérence entre les parois intérieures (14) de l'élément optique (2) et un matériau de remplissage (8).

6. Boîtier selon l'une quelconque des revendications 1 à 5 pour lequel l'élément optique (2) contient un matériau de conversion de luminescence (9).

7. Boîtier selon l'une quelconque des revendications 1 à 5 pour lequel un matériau de conversion de luminescence (9) est appliqué en une couche au moins par endroits sur les parois intérieures (14) de l'élément optique (2).

8. Boîtier selon l'une quelconque des revendications 1 à 7 pour lequel l'élément optique (2) contient au moins un des matériaux suivants : aluminium, oxyde d'aluminium, polymère liquide cristallin, polyétheréthercétone, polyphthalamide, oxyde de silicium, nitrure de silicium.

9. Composant optoélectronique comprenant un boîtier selon l'une quelconque des revendications 1 à 8 et au moins une puce à diode électroluminescente (1), la puce à diode électroluminescente (1) comportant un empilement de couches de croissance épitaxiale duquel le substrat de croissance est enlevé.

10. Procédé de production d'un composant optoélectronique avec les étapes suivantes :
a) fixation d'une puce à semi-conducteurs (1) sur un support (7),
b) mise en contact électrique de la puce à semi-conducteurs (1),
c) fixation d'un élément optique (2) sur le support (7), **caractérisé en ce que** l'élément optique (2) est mécaniquement relié au support (7) dans l'étape de procédé c) au moyen d'un ajustage serré, au moins une cavité étant prévue dans le support (7) et dans l'élément optique (2), dans laquelle cavité une tige (13) est insérée, qui comporte une extension plus grande que la cavité dans le support (7) et dans l'élément optique (2) de manière à ce qu'en enfonçant la tige (13) dans les cavités, la tige (13) est mécaniquement reliée de façon stable au support (7) et à l'élément optique (2).

11. Procédé selon la revendication 10, la puce à semi-conducteurs (1) étant mise en contact dans l'étape de procédé b) au moyen de microsoudage filaire (4).

12. Procédé selon l'une quelconque des revendications 10 ou 11, un revêtement réfléchissant étant appliqué avant l'étape de procédé c) sur les parois intérieures (14) de l'élément optique (2).

13. Procédé selon la revendication 12, le revêtement réfléchissant étant appliqué par épitaxie chimique pulsée en phase vapeur (PICVD).

14. Procédé selon l'une quelconque des revendications 10 à 13, une couche étant appliquée avant l'étape de procédé c) sur les parois intérieures (14) de l'élément optique (2), celle-ci comprenant un matériau de conversion de luminescence (9).

15. Procédé selon l'une quelconque des revendications 10 à 14, une couche (10) étant appliquée avant l'étape de procédé c) sur les parois intérieures (14) de l'élément optique (2), celle-ci comprenant un agent adhésif.

16. Procédé selon la revendication 15, l'agent adhésif étant appliqué par pyrolyse à la flamme sur les parois intérieures (14) de l'élément optique.
